# EUROPÄISCHE PATENTSCHRIFT

(11) **EP 1 050 517 B1**
(45) Veröffentlichungstag und Bekanntmachung des Hinweises auf die Patenterteilung: **02.10.2002**
(21) Anmeldenummer: 00108144.7
(22) Anmeldetag: 13.04.2000
(51) Int. Cl.: C03C 17/30, C03C 17/22

(54) **Glasbehälter für medizinische Zwecke**
Glass container for medical purposes
Récipient en verre pour utilisation médicinale

(30) Priorität: 07.05.1999 DE 19921303
(43) Veröffentlichungstag der Anmeldung: 08.11.2000
(73) Patentinhaber: Schott Glas, 55122 Mainz (DE); CARL-ZEISS-STIFTUNG trading as Schott Glas, 55122 Mainz (DE)
(72) Erfinder: Walther, Marten, Dr., 55270 Engelstadt (DE); Geiger, Andreas, 32278 Kirchlengern (DE); Auchter-Krummel, Petra, Dr., 55578 Vendersheim (DE); Spallek, Michael, Dr., 55218 Ingelheim (DE)
(74) Vertreter: Fuchs Mehler Weiss & Fritzsche

(56) Entgegenhaltungen:
- EP-A- 0 252 870
- EP-A- 0 811 367
- EP-A- 0 881 197
- DE-C- 19 629 877
- M WALTHER ET AL: "Multilayer barrier coating system produced by plasma-impulse chemical vapor deposition (PICVD)" SURFACE AND COATINGS TECHNOLOGY,NL,AMSTERDAM, Bd. 80, 1996, Seiten 200-202, XP002099295

## Beschreibung

Die Erfindung bezieht sich auf einen Glasbehälter für medizinische Zwecke zum Aufbewahren von pharmazeutischen oder diagnostischen Lösungen mit einer Antihaftbeschichtung gegenüber diesen Lösungen auf seiner Innenoberfläche.

Glasbehälter für medizinische Zwecke, d.h. Behälter mit Pharmazeutika oder Diagnostika als Inhaltsstoffe, sind in den vielfältigsten Ausführungsformen auf dem Markt, um dem jeweiligen Anwendungszweck bzw. der zugehörigen Verabreichungsform und um letzlich auch dem jeweiligen Inhaltsstoff Rechnung zu tragen.

Bei medizinischen Inhaltsstoffen strebt man an, daß das Innere des Glasbehälters möglichst keine Haftung zum Inhalt aufweist, d.h. einen möglichst großen Benetzungswinkel zu wässrigen Inhaltsstoffen aufweist, um damit auch eine vollständige Restentleerung zu ermöglichen. Dies gilt insbesondere für relativ kleine Glasbehälter mit sehr teuren Inhaltsstoffen.

Es ist bekannt, Glasbehälter für medizinische Zwecke mit Hilfe von Silikonöl (Polydimethylsiloxan-Öl) oder Silikonölemulsionen zu behandeln, um eine Antihaft-Oberfläche zu erzielen. Stellvertretend für viele Schriften wird auf die US-A-2,504,482 verwiesen. Dieses Verfahren wird auch im Europäischen Arzneibuch beschrieben.

Zentraler Nachteil dieser Methode ist die Abgabe von Silikonöl aus der Oberfläche und die damit verbundene Gefahr der Einbringung dieser Substanz in den menschlichen oder tierischen Körper. Ferner treten unerwünschte Adsorptionsphänomene an silikonbeschichteten Oberflächen auf, die sich insbesondere proteinbindend bemerkbar machen. Ferner sind schwermetallhaltige Verunreinigungen bei Silikonölen unvermeidlich. Deshalb sind entsprechende aufwendige Prüfungen im Europäischen Arzneibuch vorgeschrieben. Ferner sind Hilfsstoffe (z.B. Detergentien) kritisch, wie sie zur Stabilisierung von Silikonölemulsionen eingesetzt werden müssen.

Neben der Aufbringung von Silikonöl sind Verfahren zur Oberflächenmodifikation durch Verwendung von Silanen, Silatanen, etc. bekannt (GB 2 230 260 A). Hierbei wird nach einem aufwendigen Reinigungsprozeß, der oftmals die Verwendung von aggressiven Säuren, wie Chrom-Schwefelsäure, etc. beinhaltet, eine monomolekulare Schicht aus der Flüssig- oder Gasphase aufgebracht.

Diese Verfahren haben den Nachteil, daß nach der Oberflächenbehandlung ein erneuter aufwendiger Waschprozeß notwendig ist, um Restchemikalien weitestgehend zu entfernen. Ferner sind bislang keine Silanisierungsschichten bekannt, die den einschlägigen typischen pharmazeutischen Tests genügen, insbesondere eine Autoklavierung (121°C/20 min) überstehen.

Der Erfindung liegt die Aufgabe zugrunde, den eingangs bezeichneten Glasbehälter für medizinische Zwecke so auszubilden, daß seine Innenoberfläche eine ausgeprägte Antihafteigenschaft besitzt, die auch den typischen pharmazeutischen Streß-Testbedingungen gewachsen ist und kein Silikon in die im Glasbehälter befindliche Lösung abgibt. Die Lösung dieser Aufgabe gelingt gemäß der Erfindung mit einem Glasbehälter für medizinische Zwecke zum Aufbewahren von pharmazeutischen oder diagnostischen Lösungen, dessen innere Oberfläche über die gesamte Innenfläche bis zum Verschlußrand mit einer amorphen, transparenten und pharmatauglichen Antihaftschicht mit Kontaktwinkeln zu Wasser von ≥ 80° auch nach einer Autoklavierung für ca. 20 min bei ca. 120° C versehen ist, die die Elemente Si-O-C-H enthält und nach dem PECVD-Verfahren, vorzugsweise nach dem PECVD-Verfahren, aufgebracht ist.

Ein derartig medizinischer Glasbehälter besitzt eine im hohen Maße wasserabweisende Innenoberfläche, die eine nahezu vollständige Entleerung des Behälters erlaubt. Er hat weiterhin den großen medizinischen Vorteil, daß die Schicht kein Silikon in den pharmazeutischen oder diagnostischen Inhaltsstoff abgibt und damit auch nicht in den menschlichen Körper gelangen kann.

Versuche haben gezeigt, daß die erfindungsgemäße Antihaftschicht den typischen pharmazeutischen Streß-Testbedingungen gewachsen ist, d.h. den typischen Sterilisationsbedingungen ausgesetzt werden kann, ohne daß die Antihaftschicht etwas von ihrer Funktion einbüßen würde. Der erfindungsgemäße Glasbehälter ist damit auch im hohen Maße pharmatauglich.

Vorzugsweise ist die Antihaftschicht so zusammengesetzt, daß der Si-Anteil mindestens 1% und der C-Anteil mindestens 5 % beträgt. Die hydrophobe Eigenschaft kann dabei verstärkt werden, wenn gemäß einer Weiterbildung der Erfindung die Antihaftschicht Fluor enthält.

Gemäß einer Ausgestaltung der Erfindung steht dabei der prozentuale Anteil des Fluor (F) mit dem Kohlenstoffanteil gemäß den folgenden Beziehungen in Wechselwirkung:
Wenn F < 0,1%, dann C ≥ 10%
Wenn F ≥ 0,1%, dann C ≥ 5%.

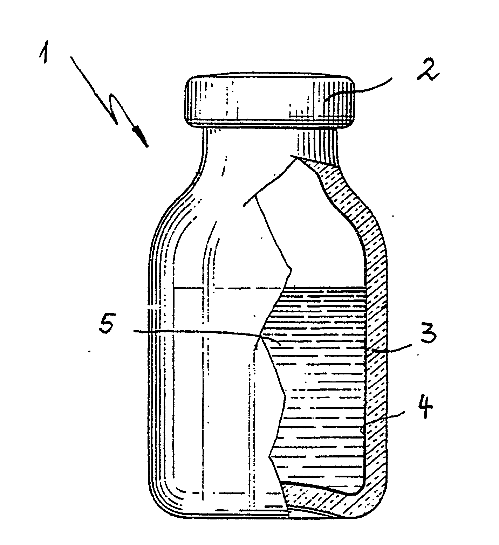

Anhand eines in der Zeichnung dargestellten Ausführungsbeispieles eines erfindungsgemäß ausgebildeten Glasbehälters für medizinische Zwecke wird die Erfindung näher beschrieben. Die einzige Figur der Zeichnung zeigt einen Glasbehälter 1 für medizinische Zwecke in einer für bestimmte Anwendungen typischen Konfiguration, der mit einem konventionellen Verschluß 2 versehen ist. Der Glasbehälter 1 dient zur Aufbewahrung einer pharmazeutischen oder diagnostischen Lösung 5.

Der Glasbehälter 1 besteht vorzugsweise aus einem Borosilikatglas entsprechend Glasart I nach Deutschem Arzneibuch, 10. Auflage. Die dargestellte Form des Glasfläschchens und die vorgenannte Glasart stellen Ausführungsbeispiele dar. Es können prinzipiell auch andere Formen von Glasbehältern und andere Glasarten, die die geforderten Eigenschaften besitzen, Anwendung finden, insbesondere Gläser, die eine niedrigen hydrolytischer Klasse angehören, insbesondere die sogenannten Neutralgläser.

Es ist anzustreben, daß das Innere des Glasfläschchens im hohen Maße wasserabweisend ist, d.h. einen möglichst großen Benetzungswinkel zu den wässrigen Inhaltsstoffen 5 aufweist, um insbesondere eine vollständige Restentleerung zu ermöglichen. Dies gilt insbesondere für relativ kleine Glasbehälter mit sehr teuren Inhaltsstoffen.

Um dies zu erreichen, weist die innere Oberfläche der Wandung 3 des Glasfläschchens 1 eine spezielle Beschichtung 4 auf. Diese Beschichtung besteht aus einer Antihaftschicht mit Kontakwinkeln zu Wasser von ≥ 80°, die pharmatauglich ist, d.h. schwermetallfrei und stabil gegenüber den üblichen Testbedingungen ist, insbesondere einer Autoklavierung mit 121°C bei 20-minütiger Dauer und/oder einer Heißluftsterilisation mit 300°C bei 30 minütiger Dauer widersteht. Die Schicht ist amorph, klar und transparent und enthält die Eklemente Si-O-C-H, mit einem Si-Anteil von mindestens 1% und einem C-Anteil von mindestens 5%. Vorzugsweise enthält die Schicht 4 auch Fluor, dessen Anteil in Wechselwirkung mit dem C-Anteil steht.

Es gilt:
Wenn F < 0,1%, dann C ≥ 10%
Wenn F ≥ 0,1 %, dann C ≥ 5%.

Die Schicht 4 wird mittels eines Plasma-Enhanced-Verfahrens (PECVD-Verfahren) erzeugt. Bei diesem Verfahren findet eine plasmaunterstützte Schichtabscheidung aus der Gasphase (Chemical Vaport Deposition = CVD) statt, wobei die Schichtstoffe in Form sogenannter Precursorgase gasförmig zugeführt werden. Diese Precursorgase werden gespalten, wobei die erforderliche Energie durch ein elektrisches Hochfrequenzplasma, im speziellen bei dem PICVD-Verfahren (Plasma-Impuls-CVD-Verfahren) impulsweise, in das System eingebracht wird.

Diess Verfahren und die zugehörige Vorrichtungen sind wohlbekannt, beispielsweise durch die DE 196 29 877 C1 und die DE 44 38 359 A1, beides Schriften der Patentanmelderin.

Der erfindungsgemäße Behälter für medizinische Zwecke weist folgende vorteilhafte Eigenschaften auf:

Er ist:
a) wasserabweisend, um einen möglichst großen Benetzungswinkel zu wäßrigen Inhaltsstoffen zu erreichen, um damit auch eine vollständige Restentleerung zu ermöglichen,
b) nicht proteinbindend wirksam,
c) frei von Silikon (Poly-(Dimethysiloxanen),
d) stabil gegenüber typischen pharmazeutischen Streß-Testbedingungen bzw. Terminalsterilisation (Autoklavierung mit Dampf bei 121°C/20 Minuten),
   und besitzt zudem
e) eine hohe Transparenz,
f) eine hohe Stabilität gegenüber dem Wasch-, Trockungs-, Heißluftsterilisations-, Abfüll- und Verschließprozeß; hierzu gehört eine Waschprozeß mit heißem, destilliertem Wasser sowie eine Heißluftsterilisation bei Temperaturen bis zu 300°C und Verweilzeiten bis zu 30 Minuten,
g) eine chemische Reinheit, d.h. kommt ohne die Verwendung von Lösungsmitteln, bzw. aggressiven Chemikalien zur Oberflächenaktivierung/Reinigung aus,
   sowie läßt sich durch ein einfaches Verfahren herstellen.

Überraschenderweise hat sich ferner gezeigt, daß nicht nur die Haftung von Partikeln in wäßrigen Suspensionen an der Behälterinnenoberfläche drastisch reduziert wird, sondern daß dies auch für die Suspension gilt, die ein inertes Treibgas, wie z.B. R134a, R127 enthält. Dasselbe gilt für Suspensionen in Alkoholen.

### Beispiele

Stellvertretend für zahlreiche Versuche werden nachstehend zwei Beispiele beschrieben, die die überlegenen Eigenschaften des erfindungsgemäßen Glasbehälters zeigen.

### Beispiel 1

### Beschichten nach dem PECVD-Verfahren

Glasbehälter in Form von Glasflaschen werden in einem PECVD-Reaktor, dessen Aufbau prinzipiell der in der zitierten DE 44 38 359 A1 beschriebenen Vorrichtung entspricht, aufgestellt. Eine Gasdüsenanordnung reicht dabei in die Mündung der Flaschen hinein. Der Reaktor wird durch eine Pumpe evakuiert auf 0,05 mb. Dann wird durch Gasdüsen ein Gemisch aus HMDSO (5sccm) und C₆F₁₀(CF₃)₂ (2sccm) eingeleitet. Durch ein Anpaßnetzwerk wird die RF-Leistung über eine Elektrode induktiv über Spulen in den Reaktor eingekoppelt und zündet dort ein Plasma. Die Gesamtanordnung befindet sich dabei innerhalb einer elektrischen Abschirmung. In diesem Prozeß setzt sich bei ca. 300W-HF-Leistung (13,56 MHz) das Reaktionsgas zu einer Schicht auf der gesamten Flasche um. Sobald die Schichtdicke im Inneren der Fläschchen 20 nm erreicht hat, wird der Reaktor abgeschaltet, belüftet und die Flaschen werden entnommen.

Alle Flaschen weisen einen Kontaktwinkel von 95° - 102° (gegenüber Wasser) auf, der durch Autoklavieren bei 121° C für 20 Minuten auf 85° - 95° zurückgeht. Allen Flaschen wurde eine wässrige Suspension eingefüllt. Nach einer Lagerdauer von 1 Woche wurde das Ablaufverhalten untersucht. Im Gegensatz zu den unbeschichteten Flaschen, bei denen nach Entleerung Suspensionsreste fleckig über die gesamten Innenwände verblieben, konnten die mit dem beschriebenen Verfahren beschichteten Flaschen vollständig entleert werden.

### Beispiel 2

### Beschichten nach dem PICVD-Verfahren

Glasbehälter in Form von Glasflaschen werden in einen PICVD-Reaktor, dessen Aufbau der in der zitierten DE 196 298 77 C1 beschriebenen Vorrichtung entspricht, eingebracht. Die Glasflasche wird durch die Pumpe auf 0,9 mbar evakuiert. In diese Flasche wird durch die Gasversorgung ein Gasgemisch aus 10 sccm HMDSO, 5 sccm O₂ und 2 sccm C₆F₆ eingeleitet. Durch eine Mikrowellenversorgung wird eine gepulste Leistung bei 2,45 GHz angeboten, die innerhalb der Glasflasche ein Plasma zündet. Nach einer Abscheidung von 30 nm Schicht wird die Mikrowelle ausgeschaltet und die Flaschen werden belüftet. Die Tests an diesen Flaschen ergaben Kontaktwinkel von 91° - 105° gegenüber Wasser, die nach Autoklavierung im Mittel um 6° zurückgingen. Das Verhalten beim Ablauf wässriger Suspensionen entsprach dem Verhalten der Flaschen aus dem oben beschriebenen PECVD-Prozeß.

## Patentansprüche

1. Glasbehälter für medizinische Zwecke zum Aufbewahren von pharmazeutischen oder diagnostischen Lösungen, dessen innere Oberfläche über die gesamte Innenfläche bis zum Verschlußrand mit einer amorphen, transparenten und pharmatauglichen Antihaftschicht (4) mit Kontaktwinkeln zu Wasser von ≥ 80° auch nach einer Autoklavierung für ca. 20 min. bei ca. 120° C versehen ist, die die Elemente Si-O-C-H enthält und nach dem PECVD-Verfahren, aufgebracht ist.

2. Glasbehälter nach Anspruch 1, **dadurch gekennzeichnet, daß** die Antihaftschicht nach dem PICVD-Verfahren, aufgebracht ist.

3. Glasbehälter nach Anspruch 1 oder 2, **dadurch gekennzeichnet, daß** der Si-Anteil mindestens 1% beträgt.

4. Glasbehälter nach Anspruch 1 oder 2, **dadurch gekennzeichnet, daß** der C-Anteil mindestens 5 % beträgt.

5. Glasbehälter nach einem der Ansprüche 1 bis 4, **dadurch gekennzeichnet, daß** die Schicht Fluor enthält.

6. Glasbehälter nach Anspruch 5, **dadurch gekennzeichnet, daß** der prozentuale Anteil des Fluor (F) mit dem Kohlenstoffanteil gemäß den folgenden Beziehungen in Wechselwirkung steht:
WennF < 0,1% dann C ≥ 10%
Wenn F ≥ 0,1% dann C ≥ 5%.

## Claims

1. Glass container for medical purposes for storing pharmaceutical or diagnostic solutions, the inner surface of which is provided, over the entire inner face all the way to the closure rim, with an amorphous, transparent and pharmaceutically acceptable anti-adherent coating (4) with contact angles with respect to water of ≥ 80° even after autoclaving at approx. 120°C for approx. 20 min, which coating contains the elements Si-O-C-H and is applied using the PECVD process.

2. Glass container according to Claim 1, **characterized in that** the anti-adherent coating is applied using the PICVD process.

3. Glass container according to Claim 1 or 2, **characterized in that** the Si content is at least 1%.

4. Glass container according to Claim 1 or 2, **characterized in that** the C content is at least 5%.

5. Glass container according to one of Claims 1 to 4, **characterized in that** the layer contains fluorine.

6. Glass container according to Claim 5, **characterized in that** the percentage fluorine (F) content interacts with the carbon content in accordance with the following relationships:
If F < 0.1% then C ≥ 10%
If F ≥ 0.1% then C ≥ 5%.

## Revendications

1. Récipient en verre destiné à des utilisations médicales, en vue de la conservation de solutions pharmaceutiques ou diagnostiques, dont la surface intérieure est pourvue, sur toute la surface intérieure jusqu'au bord de fermeture, d'une couche antiadhésive amorphe, transparente et acceptable en pharmacie (4), avec des angles de contact à l'égard de l'eau ≥ 80°, même après un traitement en autoclave pendant environ 20 minutes à environ 120°C, qui contient les éléments Si-O-C-H et qui est déposée suivant le procédé PECVD.

2. Récipient en verre suivant la revendication 1, **caractérisé en ce que** la couche antiadhésive est déposée suivant le procédé PICVD.

3. Récipient en verre suivant la revendication 1 ou 2, **caractérisé en ce que** la proportion de Si vaut au moins 1 %.

4. Récipient en verre suivant la revendication 1 ou 2, **caractérisé en ce que** la proportion de C vaut au moins 5 %.

5. Récipient en verre suivant l'une quelconque des revendications 1 à 4, **caractérisé en ce que** la couche contient du fluor.

6. Récipient en verre suivant la revendication 5, **caractérisé en ce que** la proportion du fluor (F), exprimée en pour cent, est en relation réciproque avec la proportion de carbone par les relations suivantes:
Si F < 0,1 %, alors C ≥ 10 %
Si F ≥ 0,1 %, alors C ≥ 5 %.
